# EUROPEAN PATENT SPECIFICATION

(11) **EP 3 450 027 B1**
(45) Date of publication and mention of the grant of the patent: **21.10.2020**
(21) Application number: 18174151.3
(22) Date of filing: 24.05.2018
(51) Int. Cl.: B06B 1/06, B41J 2/14, H01L 41/08, H01L 41/09

(54) **PIEZOELECTRIC DEVICE, LIQUID DISCHARGING HEAD, AND LIQUID DISCHARGING APPARATUS**
PIEZOELEKTRISCHE VORRICHTUNG, FLÜSSIGKEITSAUSSTOSSKOPF UND FLÜSSIGKEITSAUSSTOSSVORRICHTUNG
DISPOSITIF PIÉZOÉLECTRIQUE, TÊTE DE DÉCHARGE DE LIQUIDE ET APPAREIL DE DÉCHARGE DE LIQUIDE

(30) Priority: 29.05.2017 JP 2017105591
(43) Date of publication of application: 06.03.2019
(73) Proprietor: Seiko Epson Corporation, Tokyo 160-8801 (JP)
(72) Inventor: YAMASAKI, Sayaka, Suwa-shi, Nagano 392-8502 (JP); TAMURA, Hiroaki, Suwa-shi, Nagano 392-8502 (JP)
(74) Representative: Miller Sturt Kenyon

(56) References cited:
- JP-A- H11 227 204
- JP-A- 2005 119 044
- JP-A- 2014 198 406
- US-A1- 2016 311 221
- US-A1- 2017 119 350

## Description

### BACKGROUND

### 1. Technical Field

The present invention relates to a technique in which a piezoelectric device causes a pressure change.

### 2. Related Art

A liquid discharging head that discharges, from nozzles, a liquid such as an ink supplied to a pressure chamber by a piezoelectric device causing a pressure change in the pressure chamber is proposed in the related art. For example, a technique, in which a piezoelectric device including a diaphragm configuring a wall surface (top surface) of a pressure chamber and a piezoelectric element vibrating the diaphragm is provided for each pressure chamber, is disclosed in JP-A-2002-67307. An active layer substrate (portion that deforms due to vibration) of the diaphragm is configured of a silicon base of which a Young's modulus changes according to a direction in a crystal plane. In JP-A-2002-67307, the diaphragm is made likely to deform in a lateral direction by aligning the lateral direction of the diaphragm with a direction, in which a Young's modulus of the diaphragm in the lateral direction is lower than a Young's modulus of the diaphragm in a longitudinal direction, in a crystal plane. Thus, the displacement properties of the diaphragm are enhanced.

However, not only a Young's modulus but also a Poisson's ratio has anisotropy according to a crystal plane of the silicon base. Moreover, the Poisson's ratio and the Young's modulus are different from each other in terms of how the Poisson's ratio and the Young's modulus change according to a direction in the crystal plane. Therefore, even if a direction of the diaphragm is aligned with a direction in the crystal plane considering only a Young's modulus, a crack is likely to be generated in the diaphragm according to a Poisson's ratio in that direction. Thus, there is a possibility that the piezoelectric device becomes damaged.

JP H11-227204 discloses an ink jet recording head that comprises a nozzle plate having a nozzle for jetting ink, a substrate on which a pressure room is formed in order to jet ink through the nozzle, and a diaphragm formed on the substrate in order to apply pressure to the pressure room. The head has a lower electrode laminated on the diaphragm, and a piezoelectric element comprising a piezoelectric film sandwiched between upper and lower electrodes in a region of the diaphragm corresponding to the pressure room and serving as a pressure source for the diaphragm. A conductive film (principally comprising any one of IrOx, ReOx, and RuOx) receiving compressive stress is interposed between the lower electrode and the piezoelectric film.

US 2017/119350 discloses a piezoelectric element that includes a piezoelectric body and a vibrating plate including single crystal silicon having anisotropy, having an orientation with a relatively high Poisson's ratio and an orientation with a relatively low Poisson's ratio, as a vibrating material. The piezoelectric body and the vibrating plate are laminated on each other so that the low Poisson's ratio orientation is in a direction along a high expansion and contraction direction among a direction where a degree of expansion and contraction caused according to a support structure of the piezoelectric body is relatively high and a direction where a degree thereof is relatively low.

### SUMMARY

An advantage of some aspects of the invention is to suppress the generation of a crack in a diaphragm.

According to an aspect of the invention, there is provided a piezoelectric device as defined in claim 1.

According to this configuration, the Poisson's ratio in the short axis direction, which has an effect on stretching/contracting of the diaphragm in a long axis direction, is restricted to be a value that is higher than or equal to the minimum value and is lower than the average value. Therefore, even when the diaphragm is displaced in a direction of stretching due to vibration of the piezoelectric element, a force that the diaphragm contracts in the long axis direction is weak compared to a case where the Poisson's ratio of the diaphragm in the short axis direction is a high value to an extent to exceed the average value. Thus, a contracted amount in the long axis direction becomes smaller. Since the contracted amount in the long axis direction becomes smaller and the force pulling the diaphragm in the long axis direction weakens by making the Poisson's ratio in the short axis direction lower as described above, for example, stress concentration in a portion (for example, an arm portion) of the diaphragm, which contracts in the long axis direction, is also eased. Thus, the generation of a crack in the diaphragm can be suppressed.

Furthermore, even when a material (for example, a material configuring the piezoelectric element and a material between the piezoelectric element and the diaphragm), of which the Poisson's ratio exceeds 0.0864, is stacked on the diaphragm, unnecessary deformation of the diaphragm accompanying stretching/contracting of the stacked material can be suppressed. Accordingly, the diaphragm can be made unlikely to be destroyed by the stretching/contracting of the stacked material.

According to still another aspect of the invention, there is provided a liquid discharging head including the piezoelectric device as described above. A liquid that has filled the pressure chamber is discharged from a nozzle by the piezoelectric element vibrating the diaphragm to change a pressure of the pressure chamber. According to this configuration, the liquid discharging head including the piezoelectric device that can suppress the generation of a crack in the diaphragm can be provided.

According to still another aspect of the invention, there is provided a liquid discharging apparatus including the piezoelectric device as described above. A liquid that has filled the pressure chamber is discharged from a nozzle by the piezoelectric element vibrating the diaphragm to change a pressure of the pressure chamber. According to this configuration, the liquid discharging apparatus including the piezoelectric device that can suppress the generation of a crack in the diaphragm can be provided.

### BRIEF DESCRIPTION OF THE DRAWINGS

Embodiments of the invention will now be described by way of example only with reference to the accompanying drawings, wherein like numbers reference like elements.
Fig. 1 is a view illustrating a configuration of a liquid discharging apparatus according to a first embodiment of the invention.
Fig. 2 is an exploded perspective view of a liquid discharging head.
Fig. 3 is a sectional view of the liquid discharging head illustrated in Fig. 2 taken along line III-III.
Fig. 4 is a sectional view and a plan view of a piezoelectric device.
Fig. 5 is a sectional view of the piezoelectric device illustrated in Fig. 4 taken along line V-V.
Fig. 6 is a graph showing an example of anisotropy of a Poisson's ratio of a single crystal silicon base in a (100) plane.
Fig. 7 is a graph showing an example of the anisotropy of the Poisson's ratio of the single crystal silicon base in a (110) plane.
Fig. 8 is a sectional view and a plan view of an enlarged piezoelectric device according to a second embodiment.
Fig. 9 is a sectional view of the piezoelectric device illustrated in Fig. 8 taken along line IX-IX.
Fig. 10 is a sectional view of a piezoelectric device according to a modification example of a third embodiment.
Fig. 11 is a plan view of an enlarged piezoelectric device according to a fourth embodiment.
Fig. 12 is a sectional view of the piezoelectric device illustrated in Fig. 11 taken along line XII-XII.

### DESCRIPTION OF EXEMPLARY EMBODIMENTS

### First embodiment

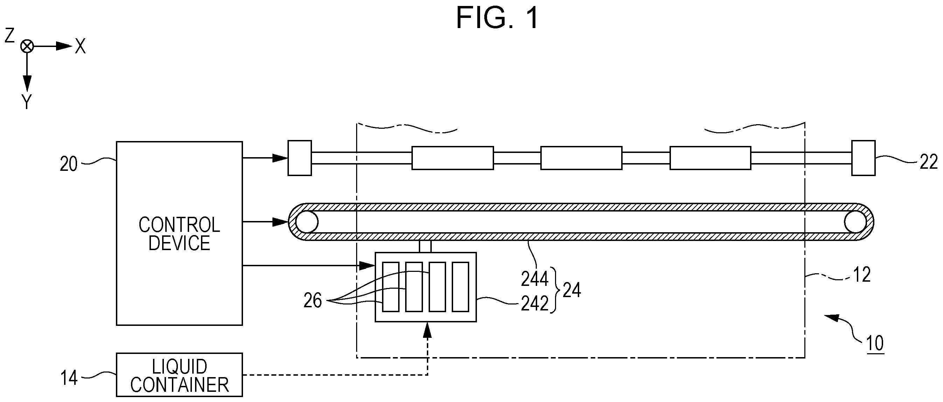

Fig. 1 is a view illustrating a configuration of a liquid discharging apparatus 10 according to a first embodiment of the invention. The liquid discharging apparatus 10 of the first embodiment is an ink jet printing apparatus that discharges an ink, which is an example of a liquid, onto a medium 12. Although the medium 12 is typical printing paper, any printing target such as a resin film and cloth can be used as the medium 12. As illustrated in Fig. 1, a liquid container 14 storing an ink is fixed to the liquid discharging apparatus 10. For example, a cartridge that is attachable/detachable to/from the liquid discharging apparatus 10, a bag-like ink pack formed of a flexible film, or an ink tank that can be refilled with an ink is used as the liquid container 14. A plurality of types of inks having different colors are stored in the liquid container 14.

As illustrated in Fig. 1, the liquid discharging apparatus 10 includes a control device 20, a transporting mechanism 22, a moving mechanism 24, and a plurality of liquid discharging heads 26. The control device 20 includes, for example, a processing circuit, such as a central processing unit (CPU) and a field programmable gate array (FPGA), and a memory circuit, such as a semiconductor memory, and comprehensively controls each element of the liquid discharging apparatus 10. The transporting mechanism 22 transports the medium 12 in a Y-direction under the control of the control device 20.

The moving mechanism 24 causes the plurality of liquid discharging heads 26 to reciprocate in an X-direction under the control of the control device 20. The X-direction is a direction intersecting (typically orthogonal to) the Y-direction in which the medium 12 is transported. The moving mechanism 24 includes a carriage 242 on which the plurality of liquid discharging heads 26 are mounted and an endless belt 244 to which the carriage 242 is fixed. It is also possible to mount the liquid container 14 on the carriage 242 with the liquid discharging heads 26.

Each of the plurality of liquid discharging heads 26 discharges an ink, which is supplied from the liquid container 14, onto the medium 12 from a plurality of nozzles (discharge holes) N under the control of the control device 20. A desired image is formed on an outer surface of the medium 12 by each of the liquid discharging heads 26 discharging an ink onto the medium 12 as the transportation of the medium 12 by the transporting mechanism 22 and the repeated reciprocation of the carriage 242 are performed at the same time. Hereinafter, a direction perpendicular to an XY-plane (for example, a plane parallel to the outer surface of the medium 12) will be referred to as a Z-direction. A direction (typical vertical direction), in which an ink is discharged by each of the liquid discharging heads 26, corresponds to the Z-direction.

### Liquid discharging head

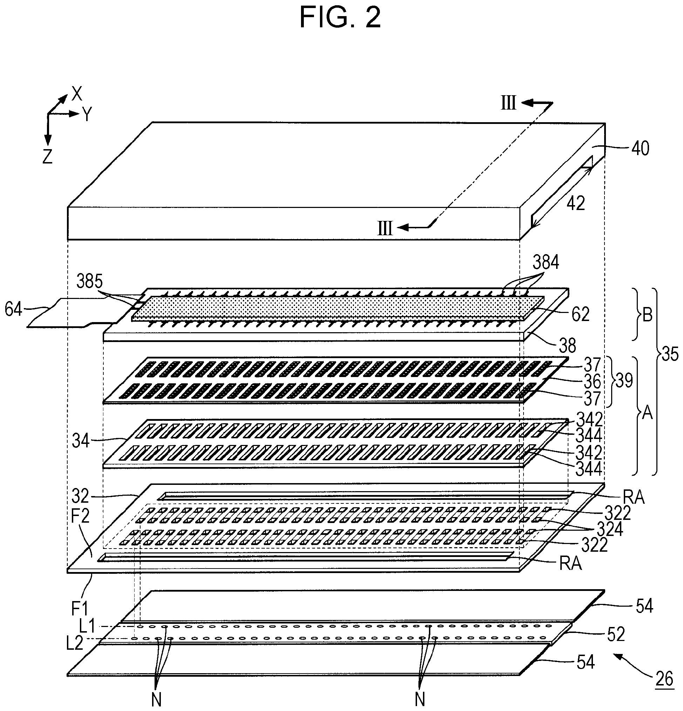

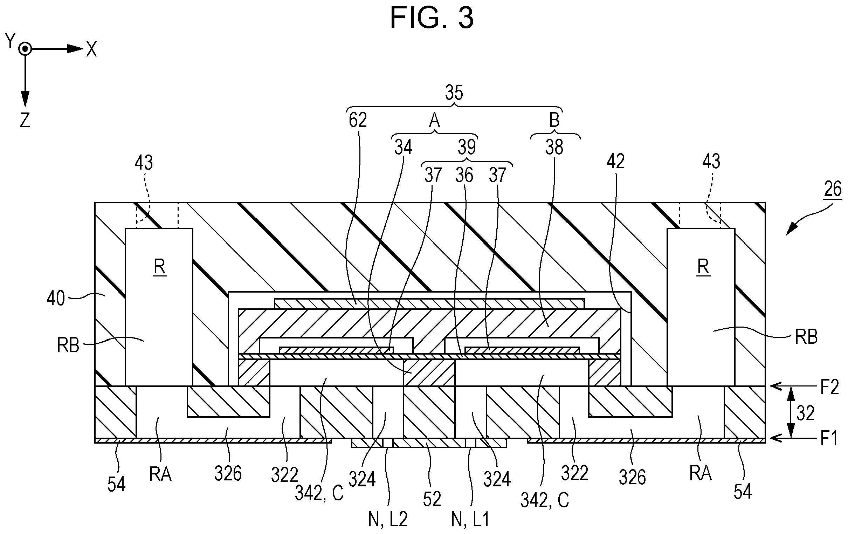

Fig. 2 is an exploded perspective view of any one of the liquid discharging heads 26, and Fig. 3 is a sectional view taken along line III-III of Fig. 2. As illustrated in Fig. 2, the liquid discharging head 26 includes the plurality of nozzles N arranged in the Y-direction. The plurality of nozzles N of the first embodiment are classified into a first line L1 and a second line L2. Although it is also possible to make the positions of the nozzles N in the Y-direction different from each other between the first line L1 and the second line L2 (that is, zigzag disposition or staggered disposition), a configuration where the positions of the nozzles N in the Y-direction match the first line L1 and the second line L2 is given as an example in Fig. 3 for convenience. As illustrated in Fig. 2, the liquid discharging head 26 has a structure in which elements related to the plurality of nozzles N in the first line L1 and elements related to the plurality of nozzles N in the second line L2 are disposed so as to be substantially linearly symmetric to each other.

As illustrated in Figs. 2 and 3, the liquid discharging head 26 includes a flow path substrate 32. The flow path substrate 32 is a plate-like member including an outer surface F1 and an outer surface F2. The outer surface F1 is an outer surface (outer surface on a medium 12 side) on a positive side of the Z-direction, and the outer surface F2 is an outer surface on a side (negative side of the Z-direction) opposite to the outer surface F1. A pressure generating unit 35 and a case member 40 are provided on the outer surface F2 of the flow path substrate 32, and a nozzle plate 52 and compliance substrates 54 are provided on the outer surface F1. Each element of the liquid discharging head 26 is a substantially plate-like member which is long in the Y-direction just as the flow path substrate 32. The elements are bonded to each other using, for example, an adhesive. It is also possible to perceive a direction, in which the flow path substrate 32 and a pressure chamber substrate 34 are stacked, as the Z-direction.

The pressure generating unit 35 is an element that causes a pressure change for discharging inks from the nozzles N. The pressure generating unit 35 of the embodiment is configured by a first substrate A including the pressure chamber substrate 34 and the piezoelectric device 39, a second substrate B including a wiring connection substrate (protection substrate) 38, and a drive IC 62 being bonded to each other. The piezoelectric device 39 is formed of pressure chambers C (to be described later) formed in the pressure chamber substrate 34, piezoelectric elements 37, and a diaphragm 36 disposed between the pressure chambers C and the piezoelectric elements 37, and is an element that causes a pressure change in the pressure chambers C by vibration. Details of the pressure generating unit 35 and the piezoelectric device 39 will be described later.

The nozzle plate 52 is a plate-like member in which the plurality of nozzles N are formed, and is provided on the outer surface F1 of the flow path substrate 32 using, for example, an adhesive. Each of the nozzles N is a through-hole through which an ink passes. The nozzle plate 52 of the first embodiment is manufactured by processing a single crystal silicon (Si) base (silicon substrate) using a semiconductor manufacturing technique. However, any known material or any known manufacturing method can be adopted in manufacturing the nozzle plate 52.

The flow path substrate 32 is a plate-like member for forming a flow path of an ink. As illustrated in Figs. 2 and 3, a space RA, a plurality of supply flow paths 322, and a plurality of communication flow paths 324 are formed for each of the first line L1 and the second line L2 in the flow path substrate 32. The spaces RA are long openings which run in the Y-direction in plan view (that is, seen from the Z-direction), and the supply flow path 322 and the communication flow path 324 are through-holes formed for each of the nozzles N. The plurality of supply flow paths 322 are arranged in the Y-direction, and the plurality of communication flow paths 324 are also arranged in the Y-direction. As illustrated in Fig. 3, intermediate flow paths 326 which reach the plurality of supply flow paths 322 are formed in the outer surface F1 of the flow path substrate 32. Each of the intermediate flow paths 326 is a flow path connecting the space RA and the plurality of supply flow paths 322 together. The communication flow paths 324 communicate with the nozzles N.

The wiring connection substrate 38 of Figs. 2 and 3 is a plate-like member for protecting the plurality of piezoelectric elements 37, and is provided on an outer surface (outer surface on a side opposite to the pressure chambers C) of the diaphragm 36. Although any material or any manufacturing method can be used for the wiring connection substrate 38, the wiring connection substrate 38 can be formed by processing a single crystal silicon (Si) base (silicon substrate) using a semiconductor manufacturing technique as in the case of the flow path substrate 32 and the pressure chamber substrate 34. As illustrated in Figs. 2 and 3, the drive IC 62 is provided on an outer surface of the wiring connection substrate 38 (hereinafter, referred to as a "mount surface") on a side opposite to the outer surface (hereinafter, referred to as a "bonded surface") on a diaphragm 36 side. The drive IC 62 is a substantially rectangular IC chip on which a drive circuit that drives each of the piezoelectric elements 37 by generating and supplying a drive signal under the control of the control device 20 is mounted. On the mount surface of the wiring connection substrate 38, wiring 384 connected to an output terminal for a drive signal (drive voltage) of the drive IC 62 is formed for each of the piezoelectric elements 37. In addition, each of wiring pieces 385 connected to an output terminal for a base voltage (base voltage of a drive signal of each of the piezoelectric elements 37) of the drive IC 62 is consecutively formed on the mount surface of the wiring connection substrate 38 along the disposition of the piezoelectric elements 37 in the Y-direction.

The case member 40 illustrated in Figs. 2 and 3 is a case for storing an ink to be supplied to the plurality of pressure chambers C (furthermore, the plurality of nozzles N). An outer surface of the case member 40 on the positive side of the Z-direction is fixed to the outer surface F2 of the flow path substrate 32 with, for example, an adhesive. As illustrated in Figs. 2 and 3, a grooved recessed portion 42 extending in the Y-direction is formed in the outer surface of the case member 40 on the positive side of the Z-direction. The wiring connection substrate 38 and the drive IC 62 are accommodated inside the recessed portion 42. The case member 40 is formed of a material different from materials of the flow path substrate 32 and the pressure chamber substrate 34. It is possible to manufacture the case member 40 with, for example, a resin material by injection molding. However, any known material or any known manufacturing method can be adopted in manufacturing the case member 40. For example, a synthetic fiber or a resin material is suitable as a material of the case member 40.

As illustrated in Fig. 3, a space RB is formed for each of the first line L1 and the second line L2 in the case member 40. The spaces RB of the case member 40 and the spaces RA of the flow path substrate 32 communicate with each other. A space configured of the space RA and the space RB functions as a liquid storing chamber (reservoir) R storing an ink to be supplied to the plurality of pressure chambers C. The liquid storing chamber R is a common liquid chamber that reaches the plurality of nozzles N. An inlet 43 for causing an ink to be supplied from the liquid container 14 to flow into the liquid storing chamber R is formed for each of the first line L1 and the second line L2 in the outer surface of the case member 40 on a side opposite to the flow path substrate 32.

An ink supplied from the liquid container 14 to the inlet 43 is stored in the space RB and the space RA of the liquid storing chamber R. The ink stored in the liquid storing chamber R is divided into the plurality of supply flow paths 322 from the intermediate flow paths 326 so as to be supplied to and so as to fill each of the pressure chambers C in parallel.

As illustrated in Fig. 2, the compliance substrates 54 are provided on the outer surface F1. The compliance substrates 54 are flexible films that absorb a pressure change of an ink in the liquid storing chambers R. As illustrated in Fig. 3, the compliance substrates 54 are provided on the outer surface F1 of the flow path substrate 32 so as to close the spaces RA of the flow path substrate 32, the intermediate flow paths 326, and the plurality of supply flow paths 322, and configure wall surfaces (specifically, bottom surfaces) of the liquid storing chamber R.

The pressure generating unit 35 illustrated in Fig. 3 is configured by stacking the first substrate A, the second substrate B, and the drive IC 62. The first substrate A is a substrate that includes the pressure chamber substrate 34, the diaphragm 36, and the plurality of piezoelectric elements 37, and the second substrate B is a substrate that includes the wiring connection substrate 38.

The pressure chamber substrate 34 is a plate-like member, in which a plurality of openings 342 configuring the pressure chambers C are formed for each of the first line L1 and the second line L2, and is provided on the outer surface F2 of the flow path substrate 32 using, for example, an adhesive. The plurality of openings 342 are arranged in the Y-direction. Each of the openings 342 is a through-hole, which is formed for each of the nozzles N and runs in the X-direction in plan view. The flow path substrate 32 and the pressure chamber substrate 34 are manufactured by processing single crystal silicon (Si) substrates (silicon substrates) using a semiconductor manufacturing technique as in the case of the nozzle plate 52 described above. However, any known material and any known method can be adopted in manufacturing the flow path substrate 32 and the pressure chamber substrate 34. The piezoelectric device 39 is provided on an outer surface of the pressure chamber substrate 34 on a side opposite to the flow path substrate 32.

### Piezoelectric device

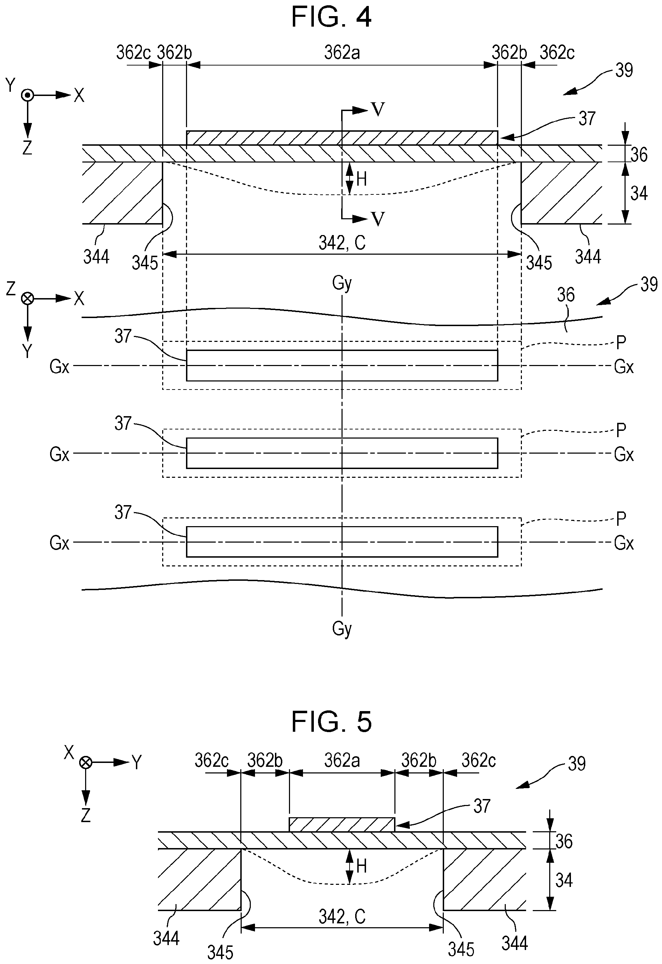

Fig. 4 is a sectional view and a plan view of the enlarged piezoelectric device 39. The sectional view (view on the upper side of Fig. 4) of Fig. 4 is a view obtained by cutting the piezoelectric device 39 with an XZ-plane, and the plan view (view on the lower side of Fig. 4) of Fig. 4 is a view in which the piezoelectric device 39 is seen from the Z-direction. Fig. 5 is a sectional view of the piezoelectric device 39 illustrated in Fig. 4 taken along line V-V. As illustrated in Figs. 4 and 5, the piezoelectric device 39 is formed of the pressure chambers C, the piezoelectric elements 37, and the diaphragm 36, and causes a pressure change in each of the pressure chambers C by the piezoelectric elements 37 vibrating the diaphragm 36. The shape of an inner periphery 345 of the pressure chamber C and the shape of the piezoelectric element 37 of Fig. 4 are, in plan view, rectangles formed of a long axis, which runs in the X-direction, and a short axis, which is shorter than the long axis and runs in the Y-direction. The shape of the inner periphery 345 of the pressure chamber C is the shape of the inner periphery 345 of a side wall 344 of the pressure chamber C in plan view seen from the Z-direction, and defines a vibration region P of the diaphragm 36. The vibration region P of the diaphragm 36 is a region of the diaphragm 36, which overlaps the pressure chamber C in plan view, and is a region that configures a wall surface (top surface) of the pressure chamber C.

As illustrated in Figs. 2 and 3, the outer surface F2 of the flow path substrate 32 and the diaphragm 36 face each other at an interval inside each of the openings 342. A space positioned inside each of the openings 342 between the outer surface F2 of the flow path substrate 32 and the diaphragm 36 functions as each of the pressure chambers C for applying a pressure to an ink which has filled the space. The pressure chamber C is separately formed for each of the nozzles N. As illustrated in Fig. 2, the plurality of pressure chambers C (openings 342) are arranged in the Y-direction for each of the first line L1 and the second line L2. Any one of the pressure chambers C communicates with the space RA via the supply flow path 322 and the intermediate flow path 326, and communicates with the nozzle N via the communication flow path 324.

On an outer surface of the diaphragm 36 on a side opposite to the pressure chambers C, the plurality of piezoelectric elements 37 corresponding to the different nozzles N are provided for each of the first line L1 and the second line L2 as illustrated in Figs. 2 to 5. The piezoelectric elements 37 are pressure generating elements that deform due to supply of a drive signal and generate pressures in the pressure chambers C. Each of the plurality of piezoelectric elements 37 is arranged in the Y-direction so as to correspond to each of the pressure chambers C.

Each of the piezoelectric elements 37 is a stacked body of which a piezoelectric layer is sandwiched between a first electrode and a second electrode, which face each other. By applying a voltage to an area between the first electrode and the second electrode, a piezoelectric strain occurs in the piezoelectric layer sandwiched between the first electrode and the second electrode and thus the piezoelectric layer is displaced. Therefore, each of the piezoelectric elements 37 is a portion in which the first electrode, the second electrode, and the piezoelectric layer overlap each other. A pressure in each of the pressure chambers C changes by the diaphragm 36 vibrating in tandem with the piezoelectric strain of the piezoelectric layer. An adhesive layer for ensuring adhesion may be provided between the piezoelectric elements 37 and the diaphragm 36. That is, it is not necessary for the piezoelectric elements 37 to be directly provided on the outer surface of the diaphragm 36, and the piezoelectric elements may be provided on the outer surface of the diaphragm 36 via the adhesive layer. Zirconium, a zirconium oxide, titanium, a titanium oxide, and a silicon oxide can be used for the adhesive layer.

As illustrated in Figs. 4 and 5, the diaphragm 36 is a plate-like member that can elastically vibrate. The diaphragm 36 of the embodiment is configured of an anisotropic single crystal silicon base of which a Poisson's ratio varies according to a direction in a crystal plane, and the outer surface of the diaphragm 36 is configured of a crystal plane of the single crystal silicon base. However, a crystal of the single crystal silicon base is not limited to being as the outer surface of the diaphragm 36, and may be included at least in the diaphragm 36. For example, in a case where the diaphragm 36 is formed by stacking a plurality of materials, the crystal of the single crystal silicon base may be included in the stacked materials. The diaphragm 36 is stacked and bonded to the side walls 344 (pressure chamber substrate 34) of the pressure chambers C and configures a wall surface (specifically, a top surface) intersecting the side walls 344 of the pressure chambers C. As described above, regions (regions configuring the top surfaces of the pressure chambers C) of the diaphragm 36, which overlap the pressure chambers C in plan view, are the vibration regions P that vibrate due to the piezoelectric elements 37.

The diaphragm 36 includes active portions 362a that overlap the piezoelectric elements 37 in plan view (seen from the Z-direction), fixed portions 362c that overlap the side walls 344 of the pressure chambers C in plan view, and arm portions 362b between the active portions 362a and the fixed portions 362c. The active portions 362a are portions that vibrate in tandem with piezoelectric strains of piezoelectric layers 373. The arm portions 362b are portions that support the active portions 362a. Each of the vibration regions P is configured of the active portion 362a and the arm portion 362b.

The vibration regions P of the embodiment have the same shape as the pressure chambers C in plan view, and are rectangles each of which has a long axis, which runs in the X-direction, and a short axis, which is shorter than the long axis and runs in the Y-direction. Hereinafter, the long axis of each of the rectangles, which runs in the X-direction, will be set as a long axis Gx of each of the vibration regions P and the short axis of each of the rectangles, which runs in the Y-direction, will be set as a short axis Gy of each of the vibration regions P. The shapes of the vibration regions P may be shapes other than a rectangle such as an ellipse and a diamond. In a case where the vibration regions P have shapes other than a rectangle, a short axis of each of the smallest rectangles which includes one of the vibration regions P is the short axis Gy of the vibration region P and a long axis of the smallest rectangle that includes the vibration region P is the long axis Gx of the vibration region P. A case where the shapes of the vibration regions P match the smallest rectangles that include the vibration regions has been described in the embodiment.

In the piezoelectric device 39 having such a configuration, displacement H in the Z-direction occurs in the active portions 362a of the vibration regions P of the diaphragm 36 due to piezoelectric strains of the piezoelectric elements 37 as illustrated with dotted lines of Figs. 4 and 5. In this case, even when the same displacement H occurs in the active portions 362a, it can be seen that the arm portion 362b in the Y-direction (direction of the short axis Gy), which is illustrated in the sectional view of Fig. 5, is deformed so as to show a curve steeper than the curve of the arm portion 362b in the X-direction (direction of the long axis Gx), which is illustrated in the sectional view of Fig. 4. The diaphragm 36 greatly stretches in the direction of the short axis Gy in which the arm portions are deformed at steep curves, and the diaphragm contracts accordingly in the direction of the long axis Gx. Although each of the active portions 362a that overlaps the piezoelectric element 37 and the vicinity thereof in plan view stretch also in the direction of the long axis Gx, the shape of the diaphragm becomes a shape of projecting to a pressure chamber C side by other portions (some parts of the active portions 362b) contracting in the direction of the long axis Gx.

In this case, the diaphragm 36 in the direction of the short axis Gy can be made easier to deform in the Z-direction, for example, by aligning each of the short axes Gy of the diaphragm 36 with a direction where a Young's modulus is low in a crystal plane since a Young's modulus of the crystal plane of a silicon base changes according to a direction in the crystal plane. By doing so, it is considered that the displacement properties of the diaphragm 36 can be improved.

However, not only the Young's modulus but also the Poisson's ratio has anisotropy according to a crystal plane of the single crystal silicon base. Moreover, the Poisson's ratio and the Young's modulus are different from each other in terms of how the Poisson's ratio and the Young's modulus change according to a direction in the crystal plane. Therefore, even if a direction of the diaphragm 36 is aligned with a direction in the crystal plane considering only a Young's modulus, a crack is likely to be generated in the diaphragm 36 according to a Poisson's ratio in that direction.

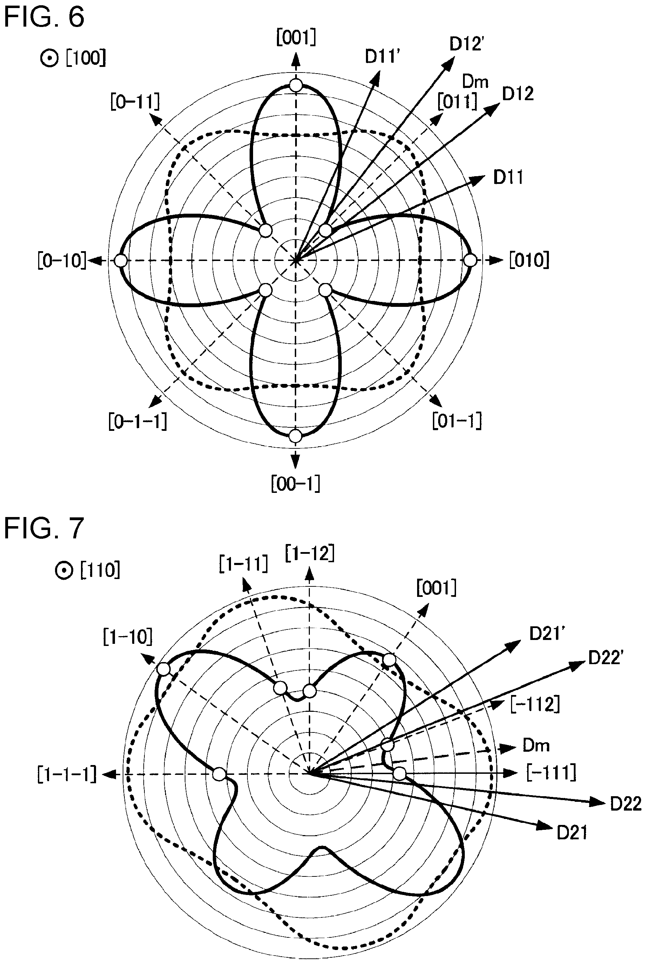

Fig. 6 is a graph showing an example of anisotropy of the Poisson's ratio and the Young's modulus in a (100) plane of a single crystal silicon base of which the crystal plane is the (100) plane (crystal plane orientation perpendicular to the crystal plane is [100]). In Fig. 6, a graph of anisotropy of the Poisson's ratio is shown with a solid line, and a graph of anisotropy of the Young's modulus is shown with a dotted line. Fig. 6 is expressed in polar coordinates, and the Young's modulus or the Poisson's ratio becomes higher as a distance from the center becomes longer.

As shown in Fig. 6, in the (100) plane of the single crystal silicon base, of which the crystal plane is the (100) plane, the Poisson's ratio has quatrefoiled anisotropy, and the Young's modulus has substantially square anisotropy. As shown in Fig. 6, the anisotropy of the Poisson's ratio is different from the anisotropy of the Young's modulus. For example, in a crystal orientation [001], the Young's modulus is the lowest while the Poisson's ratio is the highest. Therefore, for example, when a direction of the diaphragm 36 is aligned with the crystal orientation [001] in order to make the Young's modulus low, the Poisson's ratio becomes the highest. Thus, a crack is likely to be generated in the diaphragm 36 and thus there is a possibility that the piezoelectric device 39 becomes damaged.

As described above, when the diaphragm 36 is deformed due to the piezoelectric elements 37, the diaphragm greatly stretches in the direction of the short axis Gy and the diaphragm contracts accordingly in the direction of the long axis Gx. Although each of the active portions 362a and the vicinity thereof stretch also in the direction of the long axis Gx, other portions (some parts of the arm portions 362b) contract in the direction of the long axis Gx. In this case, if the Poisson's ratio in the direction of the short axis Gy is high, a contracted amount of the portion that contracts in the direction of the long axis Gx is large. Thus, a force pulling the diaphragm 36 in the direction of the long axis Gx is strong. For this reason, stress concentration occurs in some parts (for example, in plan view, a boundary between the diaphragm 36 and the pressure chambers C and a boundary between the diaphragm 36 and the piezoelectric elements 37) of the arm portions 362b that contract in the direction of the long axis Gx and thereby a crack is likely to be generated.

In the embodiment, the Poisson's ratio of the diaphragm 36 in the direction of the short axis Gy is set so as to be included in a range of a minimum value of the Poisson's ratio in the crystal plane inclusive to an average value of the Poisson's ratios in the crystal plane exclusive. The average value may be, for example, an average value calculated by dividing a value, which is obtained by adding a minimum value and a maximum value of the Poisson's ratio in the crystal plane, by 2, or may be an average value calculated by dividing a value, which is obtained by adding a plurality of sampled values of the Poisson's ratio in the crystal plane, by the number of the sampled values. According to such a configuration, a Poisson's ratio in the direction of the short axis Gy, which has an effect on stretching/contracting of the diaphragm 36 in the direction of the long axis Gx, is restricted to be a value that is higher than or equal to the minimum value and is lower than the average value. Therefore, even when the diaphragm 36 is displaced in a direction of stretching due to vibration of the piezoelectric elements 37, a force that the diaphragm 36 contracts in the direction of the long axis Gx is weak compared to a case where the Poisson's ratio of the diaphragm 36 in the direction of the short axis Gy is a high value to an extent to exceed the average value. Thus, a contracted amount in the direction of the long axis Gx is small. Since the contracted amount in the direction of the long axis Gx becomes smaller and a force pulling the diaphragm 36 in the direction of the long axis Gx weakens by making the Poisson's ratio in the direction of the short axis Gy lower as described above, for example, stress concentration of the diaphragm 36 in some parts (for example, in plan view, the boundary between the diaphragm 36 and the pressure chambers C and the boundary between the diaphragm 36 and the piezoelectric elements 37) of the arm portions 362b in the direction of the long axis Gx also is eased. Thus, the generation of a crack in the diaphragm 36 can be suppressed.

Specifically, in the (100) plane of the single crystal silicon base shown in Fig. 6, the minimum value of the Poisson's ratio is approximately 0.0664, and the average value of the Poisson's ratio is approximately 0.18065. Therefore, the range of the Poisson's ratio of the diaphragm 36 in the direction of the short axis Gy can be expressed as a range of the minimum value of the Poisson's ratio in the (100) plane inclusive to 0.18065 exclusive. An orientation Dm in which the Poisson's ratio in the (100) plane shown in Fig. 6 is the minimum value is a crystal orientation [011]. Orientations in which the Poisson's ratio is the average value are an orientation D11 of 21 degrees toward a crystal orientation [010] with respect to the crystal orientation [011] and an orientation D11' of 21 degrees toward the crystal orientation [001] with respect to the crystal orientation [011]. Therefore, the range of the Poisson's ratio of the diaphragm 36 in the direction of the short axis Gy of the first embodiment described above can also be expressed as a range of the orientation D11 to the orientation D11' with respect to the orientation Dm.

Such a diaphragm 36 of the first embodiment is manufactured using a single crystal silicon wafer of which the crystal plane is the (100) plane as shown in Fig. 6. Specifically, the diaphragm 36 of the first embodiment can be manufactured by aligning the direction of the short axis Gy of the diaphragm 36 with a crystal orientation in a crystal plane and cutting the diaphragm 36 from the single crystal silicon wafer such that the Poisson's ratio of the diaphragm 36 in the direction of the short axis Gy is included in a range (range of the orientation D11 to the orientation D11' of Fig. 6) of the minimum value of the Poisson's ratio in the crystal plane of the single crystal silicon wafer inclusive to the average value of the Poisson's ratios in the crystal plane of the single crystal silicon wafer exclusive.

As described above, it is most preferable that a Poisson's ratio of the diaphragm 36 in the direction of the short axis Gy of the first embodiment be a minimum value from a perspective of suppressing generation of a crack in the diaphragm 36. Therefore, in a case where the crystal plane of the single crystal silicon base, of which the crystal plane is the (100) plane shown in Fig. 6, is the outer surface (top surface) of the diaphragm 36, it is most effective to align the direction of the short axis Gy of the diaphragm 36 with the orientation Dm.

There is a case where stretching/contracting of a material stacked on the diaphragm 36 has an effect on the displacement H of the diaphragm 36. For example, since the piezoelectric elements 37 are stacked on the diaphragm 36 in the embodiment, there is a possibility that the displacement H of the diaphragm 36 is affected by the stretching/contracting of the stacked material according to a Poisson's ratio of the material (for example, a material of the first electrode formed on the outer surface of the diaphragm 36) configuring each of the piezoelectric elements 37 in the direction of the short axis Gy. In a case where a zirconia oxide film or a silicon oxide film is formed between each of the piezoelectric elements 37 and the diaphragm 36, there is a possibility that the displacement H of the diaphragm 36 is affected by the stretching/contracting of the stacked material. If a Poisson's ratio of the diaphragm 36 in the direction of the short axis Gy is even lower than a Poisson's ratio of the stacked material, the displacement H of the diaphragm 36 can be made unlikely to be affected by the stretching/contracting of the stacked material.

In the first embodiment, a Poisson's ratio of the diaphragm 36 in the direction of the short axis Gy is preferably 0.1 to 0.2%. When a margin is added thereto, a suitable range is set to a range of the minimum value inclusive to a value that is 30% higher than the minimum value inclusive. By doing so, the displacement is made unlikely to be affected by the stacked material on the diaphragm 36. In the single crystal silicon base of which the crystal plane is the (100) plane shown in Fig. 6, a Poisson's ratio corresponding to the value that is 30% higher than the minimum value is approximately 0.0864. Therefore, in the first embodiment, a suitable range of a Poisson's ratio of the diaphragm 36 in the direction of the short axis Gy is a range of the minimum value inclusive to 0.0864 inclusive. According to this range, even when a material, of which the Poisson's ratio in the direction of the short axis Gy of the diaphragm 36 exceeds 0.0864, is stacked on the diaphragm 36, unnecessary deformation of the diaphragm 36 accompanying stretching/contracting of the stacked material can be suppressed. In the suitable range, the Poisson's ratio of the diaphragm 36 in the direction of the short axis Gy is lower than the Poisson's ratio of the stacked material. Accordingly, since displacement of the diaphragm 36 is unlikely to be affected by stretching/contracting of the stacked material, destruction of the diaphragm 36 due to the stretching/contracting of the stacked material can be suppressed.

The orientation in which the Poisson's ratio is the minimum value in the (100) plane shown in Fig. 6 is the orientation Dm. Orientations in which the Poisson's ratio is the value that is 30% higher than the minimum value are an orientation D12 of 7 degrees toward the crystal orientation [010] with respect to the crystal orientation [011] and an orientation D12' of 7 degrees toward the crystal orientation [001] with respect to the crystal orientation [011]. Therefore, the suitable range of the Poisson's ratio of the diaphragm 36 in the direction of the short axis Gy can be expressed as a range of the orientation D12 to the orientation D12' with respect to the orientation Dm.

Although a case where the crystal plane (100) of the single crystal silicon base is the outer surface (top surface) of the diaphragm 36 has been described in the embodiment, the configuration of the embodiment is applicable also to a case where a (010) plane or a (001) plane, which is a crystal plane equivalent to the crystal plane (100), is the outer surface (top surface) of the diaphragm 36 since single crystal silicon has a cubic crystal system. Even when the crystal plane is the (010) plane or the (001) plane, the Poisson's ratio and the Young's modulus are in shapes shown in Fig. 6. However, in a case where the crystal plane is the (010) plane, crystal orientations [-100], [-101], and [001] are applied by replacing the three reference crystal orientations [010], [011], and [001] in Fig. 6, respectively. In a case where the crystal plane is the (001) plane, crystal orientations [010], [-110], and [-100] are applied by replacing the crystal orientations [010], [011], and [001] in Fig. 6, respectively. As described above, all of the crystal planes (100), (010), and (001) are equivalent to each other, and a plane group of the crystal planes can be altogether referred to as a crystal plane {100}.

### Second embodiment

A second embodiment of the invention will be described. In each form to be given as an example below, elements, of which operation and functions are the same as in the first embodiment, will be assigned with the same reference signs used in describing the first embodiment and detailed description of each of the elements will be omitted as appropriate. Although a case where the diaphragm 36 is formed of the single crystal silicon base, of which the crystal plane is the (100) plane, is given as an example in the first embodiment, a case where the diaphragm 36 is formed of a single crystal silicon base, of which the crystal plane is a (110) plane (crystal plane orientation perpendicular to the crystal plane is [110]), will be given as an example in the second embodiment.

Fig. 7 is a graph showing an example of anisotropy of a Poisson's ratio and a Young's modulus in the (110) plane of the single crystal silicon base of which the crystal plane is the (110) plane. In Fig. 7, a graph of anisotropy of the Poisson's ratio is shown with a solid line, and a graph of anisotropy of the Young's modulus is shown with a dotted line. Fig. 7 is expressed in polar coordinates, and the Young's modulus or the Poisson's ratio becomes higher as a distance from the center becomes longer.

As shown in Fig. 7, in the (110) plane of the single crystal silicon base, the Poisson's ratio has quatrefoiled anisotropy, and the Young's modulus has substantially rectangular anisotropy. As shown in Fig. 7, the anisotropy of the Poisson's ratio is different from the anisotropy of the Young's modulus and is in a shape different from the shape of Fig. 6. Therefore, even if a direction of the diaphragm 36 is aligned with a direction in the crystal plane considering only a Young's modulus also in the case of the single crystal silicon base of which the crystal plane is the (110) plane, a crack is likely to be generated in the diaphragm 36 according to a Poisson's ratio in that direction.

The Poisson's ratio of the diaphragm 36 in the direction of the short axis Gy is set so as to be included in a range of a minimum value of the Poisson's ratio in the crystal plane inclusive to an average value of the Poisson's ratios in the crystal plane exclusive, also in the second embodiment as in the first embodiment. Specifically, in the (110) plane of the single crystal silicon base shown in Fig. 7, the minimum value of the Poisson's ratio is approximately 0.1514, and the average value of the Poisson's ratios is approximately 0.24127. Therefore, the range of the Poisson's ratio of the diaphragm 36 in the direction of the short axis Gy can be expressed as a range of the minimum value of the Poisson's ratio in the (110) plane inclusive to 0.24127 exclusive. The orientation Dm in which the Poisson's ratio in the (110) plane shown in Fig. 7 is the minimum value is an orientation of 7 degrees from a crystal orientation [-111] toward a crystal orientation [-112]. Orientations in which the Poisson's ratio is the average value are an orientation D21 of 20 degrees toward the crystal orientation [-111] with respect to the orientation Dm and an orientation D21' of 25 degrees toward the crystal orientation [-112] with respect to the orientation Dm. Therefore, the range of the Poisson's ratio of the diaphragm 36 in the direction of the short axis Gy of the second embodiment described above can also be expressed as a range of the orientation D21 to the orientation D21' with respect to the orientation Dm.

According to such a second embodiment, a Poisson's ratio in the direction of the short axis Gy which has an effect on stretching/contracting of the diaphragm 36 in the direction of the long axis Gx is restricted to be a value that is higher than or equal to the minimum value and is lower than the average value, as in the first embodiment. Therefore, even when the diaphragm 36 is displaced in a direction of stretching due to vibration of the piezoelectric elements 37, a force exerted in a direction where the diaphragm 36 contracts, which is a long axis direction, is weak compared to a case where the Poisson's ratio of the diaphragm 36 in the direction of the short axis Gy is a high value to an extent to exceed the average value. Thus, a contracted amount in the direction of the long axis Gx is small. Since the contracted amount in the direction of the long axis Gx becomes smaller and a force pulling the diaphragm 36 in the direction of the long axis Gx weakens by making the Poisson's ratio in the direction of the short axis Gy lower as described above, for example, stress concentration of the diaphragm 36 in some parts (for example, in plan view, the boundary between the diaphragm 36 and the pressure chambers C and the boundary between the diaphragm 36 and the piezoelectric elements 37) of the arm portions 362b in the direction of the long axis Gx also is eased. Thus, the generation of a crack in the diaphragm 36 can be suppressed.

Such a diaphragm 36 of the second embodiment is manufactured using a single crystal silicon wafer of which the crystal plane is the (110) plane as shown in Fig. 7. Specifically, the diaphragm 36 of the second embodiment can be manufactured by aligning the direction of the short axis Gy of the diaphragm 36 with a crystal orientation in a crystal plane and cutting the diaphragm 36 from the single crystal silicon wafer such that the Poisson's ratio of the diaphragm 36 in the direction of the short axis Gy is included in a range (range of the orientation D21 to the orientation D21' of Fig. 7) of the minimum value of the Poisson's ratio in the crystal plane of the single crystal silicon wafer inclusive to the average value of the Poisson's ratios in the crystal plane of the single crystal silicon wafer exclusive.

As described above, it is most preferable that a Poisson's ratio of the diaphragm 36 in the direction of the short axis Gy of the second embodiment be a minimum value from a perspective of suppressing generation of a crack in the diaphragm 36. Therefore, in a case where the crystal plane of the single crystal silicon base of which the crystal plane is the (110) plane shown in Fig. 7 is the outer surface (top surface) of the diaphragm 36, it is most effective to align the direction of the short axis Gy of the diaphragm 36 with the orientation Dm.

Also in the second embodiment, a Poisson's ratio of the diaphragm 36 in the direction of the short axis Gy is preferably 0.1 to 0.2%. When a margin is added thereto, a suitable range can be set to a range of the minimum value inclusive to a value that is 30% higher than the minimum value inclusive. By doing so, the displacement can be made unlikely to be affected by the stacked material on the diaphragm 36. In the single crystal silicon base of which the crystal plane is the (110) plane shown in Fig. 7, a Poisson's ratio corresponding to the value that is 30% higher than the minimum value is approximately 0.1968. Therefore, in the second embodiment, a suitable range of a Poisson's ratio of the diaphragm 36 in the direction of the short axis Gy is a range of the minimum value inclusive to 0.1968 inclusive. According to this range, even when a material, of which the Poisson's ratio in the direction of the short axis Gy of the diaphragm 36 exceeds 0.1968, is stacked on the diaphragm 36, unnecessary deformation of the diaphragm 36 accompanying stretching/contracting of the stacked material can be suppressed. In the suitable range, the Poisson's ratio of the diaphragm 36 in the direction of the short axis Gy is lower than the Poisson's ratio of the stacked material. Accordingly, since displacement of the diaphragm 36 is unlikely to be affected by stretching/contracting of the stacked material, destruction of the diaphragm 36 due to the stretching/contracting of the stacked material can be suppressed.

The orientation in which the Poisson's ratio is the minimum value in the (110) plane shown in Fig. 7 is the orientation Dm. Orientations in which the Poisson's ratio is the value that is 30% higher than the minimum value are an orientation D22 of 13 degrees toward the crystal orientation [-111] with respect to the orientation Dm and an orientation D22' of 15 degrees toward the crystal orientation [-112] with respect to the orientation Dm. Therefore, the suitable range of the Poisson's ratio of the diaphragm 36 in the direction of the short axis Gy can be expressed as a range of the orientation D22 to the orientation D22' with respect to the orientation Dm.

Although a case where the crystal plane (110) of the single crystal silicon base is the outer surface (top surface) of the diaphragm 36 has been described in the embodiment, the configuration of the embodiment is applicable also to a case where a (011) plane or a (101) plane, which is a crystal plane equivalent to the crystal plane (110), is the outer surface (top surface) of the diaphragm 36 since single crystal silicon has a cubic crystal system. Even when the crystal plane is the (011) plane or the (101) plane, the Poisson's ratio and the Young's modulus are in shapes shown in Fig. 7. However, in a case where the crystal plane is the (011) plane, crystal orientations [1-11], [1-12], [100], [21-1], [11-1], [01-1], and [-11-1] are applied by replacing the seven reference crystal orientations [-111], [-112], [001], [1-12], [1-11], [1-10], and [1-1-1] in Fig. 7, respectively. In addition, in a case where the crystal plane is the (101) plane, crystal orientations [11-1], [12-1], [010], [-121], [-1-11], [-101], and [-1-11] are applied by replacing the seven reference crystal orientations [-111], [-112], [001], [1-12], [1-11], [1-10], and [1-1-1] in Fig. 7, respectively. As described above, all of the crystal planes (110), (011), and (101) are equivalent to each other, and a plane group of the crystal planes can be altogether referred to as a crystal plane {110}.

### Third embodiment

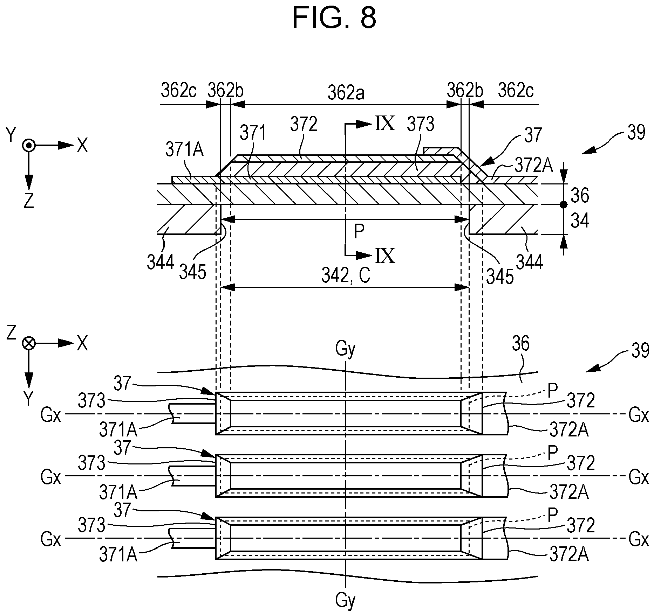

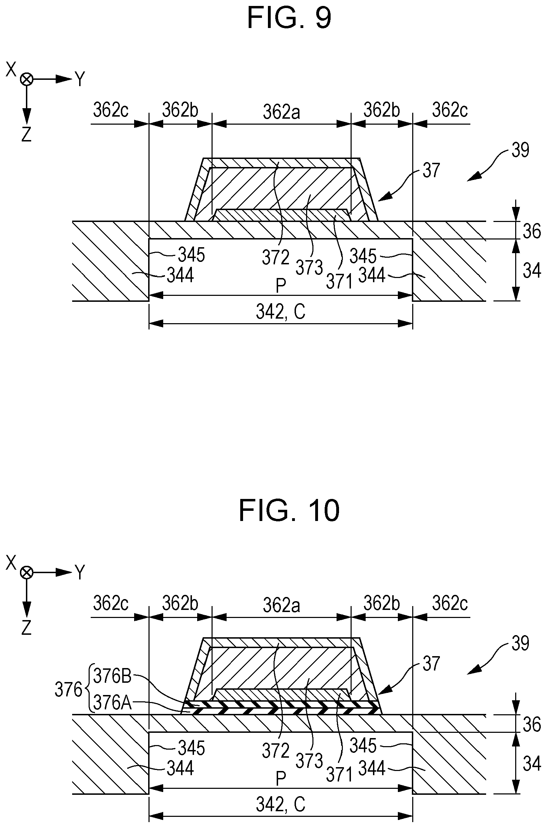

A third embodiment of the invention will be described. A specific configuration example of the piezoelectric elements 37 of the piezoelectric device 39 according to the first embodiment and the second embodiment will be described in the third embodiment. Fig. 8 is a sectional view and a plan view of the enlarged piezoelectric device 39 according to the third embodiment, and corresponds to Fig. 4. The sectional view (view on the upper side of Fig. 8) of Fig. 8 is a view obtained by cutting the piezoelectric device 39 with the XZ-plane, and the plan view (view on the lower side of Fig. 8) of Fig. 8 is a view in which the piezoelectric device 39 is seen from the Z-direction. Fig. 9 is a sectional view of the piezoelectric device 39 illustrated in Fig. 8 taken along line IX-IX.

As illustrated in the sectional view of Fig. 8 and the sectional view of Fig. 9, each of the piezoelectric elements 37 of the third embodiment is a stacked body of which the piezoelectric layer 373 is sandwiched between a first electrode 371 and a second electrode 372, which face each other. By applying a voltage to an area between the first electrode 371 and the second electrode 372, a piezoelectric strain occurs in the piezoelectric layer 373 sandwiched between the first electrode 371 and the second electrode 372 and the piezoelectric element 37 of Fig. 8 is displaced. Therefore, in the configuration of Fig. 8, a portion where the first electrode 371, the second electrode 372, and the piezoelectric layer 373 overlap each other in plan view corresponds to each of the piezoelectric elements 37 of Fig. 4. A pressure in each of the pressure chambers C changes by the diaphragm 36 vibrating in tandem with a piezoelectric strain of the piezoelectric layer 373.

The first electrode 371 is separately formed on the outer surface of the diaphragm 36 for each of the piezoelectric elements 37 (for each of the nozzles N). Each of the first electrodes 371 is an electrode that extends in the Y-direction. Each of the first electrodes 371 is connected to the drive IC 62 via each of lead electrodes 371A pulled out to the outside of each of the piezoelectric layers 373. The lead electrodes 371A are electrically connected to each other, and each first electrode 371 is a common electrode for the plurality of piezoelectric elements 37. A material that does not oxidize when forming the piezoelectric layers 373 and can maintain conductivity is preferable as a material of the first electrodes 371. For example, precious metals such as platinum (Pt) and iridium (Ir), or conductive oxides represented by lanthanum nickel oxides (LNO) are suitably used.

On an outer surface (outer surface on a side opposite to the diaphragm 36) of each of the first electrodes 371, the piezoelectric layer 373 and the second electrode 372 are separately formed for each of the piezoelectric elements 37 (for each of the nozzles N). As illustrated in Fig. 8, each of the second electrodes 372 is stacked on the first electrode 371 on the side opposite to the diaphragm 36, and each of the piezoelectric layers 373 is stacked so as to be sandwiched between the first electrode 371 and the second electrode 372. Each of the second electrodes 372 is an electrode that extends in the Y-direction. Each of the second electrodes 372 is connected to the drive IC 62 via each of lead electrodes 372A pulled out to the outside of each of the piezoelectric layers 373.

The piezoelectric layer 373 is formed by being patterned for each of the pressure chambers C. As illustrated in Fig. 8, the width of each of the piezoelectric layers 373 in the X-direction is larger than the width of each of the pressure chambers C (openings 342) in the X-direction. For this reason, each of the piezoelectric layers 373 extends to the outside of each of the pressure chambers C in the X-direction of the pressure chambers C. Therefore, the first electrodes 371 are covered with the piezoelectric layers 373 in the X-direction of the pressure chambers C.

The piezoelectric layers 373 are made of, for example, a ferroelectric ceramic material showing electromechanical conversion action, such as a crystal film (perovskite type crystal) having a perovskite structure. The material of the piezoelectric layers 373 is not limited to the material described above. For example, in addition to a ferroelectric piezoelectric material, such as lead zirconate titanate (PZT), and a ferroelectric piezoelectric material to which a metal oxide, such as a niobium oxide, a nickel oxide, and a magnesium oxide, is added, non-lead-based piezoelectric materials that do not include lead can be used without being limited to lead-based piezoelectric materials that include lead.

Each of the second electrodes 372 is provided on a surface of each of the piezoelectric layers 373 on a side opposite to each of the first electrodes 371, and configures a separate electrode corresponding to each of the plurality of piezoelectric elements 37. Each of the second electrodes 372 may be directly provided on each of the piezoelectric layers 373, or other members may be sandwiched between the piezoelectric layers 373 and the second electrodes 372. A material that can form an interface between the piezoelectric layer 373 and the material well and can demonstrate insulation properties and piezoelectric properties is desirable for the second electrodes 372. For example, a precious metal material, such as iridium (Ir), platinum (Pt), palladium (Pd), and gold (Au), or conductive oxides represented by lanthanum nickel oxides (LNO) is suitably used. The second electrodes 372 may be formed by stacking a plurality of materials.

A case where in the piezoelectric elements 37 of the embodiment, the first electrodes 371 are set as common electrodes for the plurality of piezoelectric elements 37 and the second electrodes 372 are set as separate electrodes corresponding to the plurality of piezoelectric elements 37 is given as an example. Without being limited to the configuration, however, the second electrodes 372 may be set as common electrodes for the plurality of piezoelectric elements 37 and the first electrodes 371 may be set as separate electrodes corresponding to the plurality of piezoelectric elements 37. Although a case where the diaphragm 36 is configured of a single layer is given as an example in the embodiment described above, the diaphragm may be configured of a plurality of layers without being limited thereto.

A case where the pressure chamber substrate 34 and the diaphragm 36 are configured as separate bodies is given as an example in the embodiment described above. Without being limited thereto, however, the pressure chamber substrate 34 and the diaphragm 36 may be integrated so as to form the pressure chambers C and the diaphragm 36 at once, for example, as in a modification example of the third embodiment illustrated in Fig. 10. In a configuration of Fig. 10, by selectively removing, in accordance with a crystal orientation, a part of a region corresponding to each of the pressure chambers C in a thickness direction from a single crystal silicon base having a predetermined thickness, the pressure chambers C and the diaphragm 36 can be formed at once. In the configuration of Fig. 10, adhesive layers 376 for ensuring adhesion are provided between the piezoelectric elements 37 and the diaphragm 36. Each of the adhesive layers 376 of Fig. 10 is formed of a silicon oxide film 376A and a zirconia oxide film 376B. Each of the silicon oxide films 376A and each of the zirconia oxide films 376B are stacked in this order on the diaphragm 36. Since the adhesive layers 376 have toughness lower than single crystal silicon that configures the diaphragm 36, the adhesive layers are made as thin as possible and are made so as not to be formed in portions where the arm portions 362b overlap the adhesive layers in the direction of the short axis Gy in plan view as illustrated in Fig. 10. By adopting the configuration described above, the displacement properties of the piezoelectric device 39 can be improved since the arm portions 362b are likely to deform compared to a case where the adhesive layers 376 are formed to the portions where the arm portions 362b overlap the adhesive layers in plan view.

### Fourth embodiment

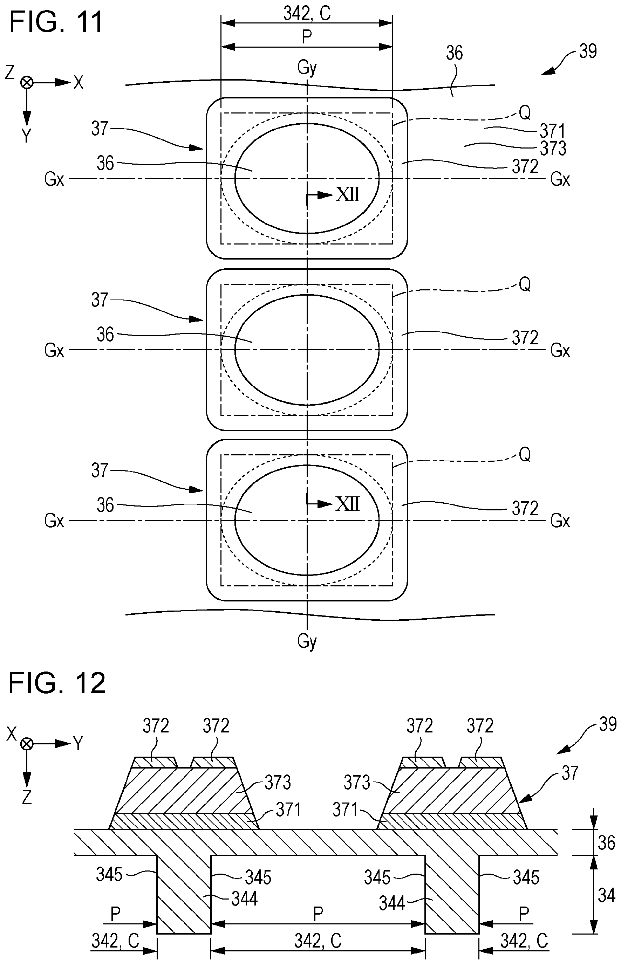

A fourth embodiment of the invention will be described. Another configuration example of the piezoelectric elements 37 of the piezoelectric device 39 according to the first embodiment and the second embodiment will be described in the fourth embodiment. Fig. 11 is a plan view of a case where the piezoelectric device 39 according to the fourth embodiment is seen from the Z-direction. Fig. 12 is a sectional view of the piezoelectric device 39 illustrated in Fig. 11 taken along line XII-XII.

As illustrated in Figs. 11 and 12, the shapes of the inner peripheries 345 of the pressure chambers C of the fourth embodiment are ellipses each of which has the long axis Gx running in the X-direction and the short axis Gy running in the Y-direction in plan view. The piezoelectric elements 37 of the fourth embodiment are disposed on peripheral portions of the pressure chambers C so as to overlap the inner peripheries 345 of the pressure chambers C without overlapping the centers of the pressure chambers C in plan view. A case where the entire perimeter of each of the piezoelectric elements 37 is annularly formed so as to overlap the entire perimeter of each of the inner peripheries 345 of the pressure chambers C in plan view is given as an example in Fig. 11. However, each of the piezoelectric elements 37 may have a configuration of overlapping a part of each of the inner peripheries 345 instead of the entire perimeter of each of the inner peripheries 345 of the pressure chambers C.

Each of the piezoelectric elements 37 of the fourth embodiment is a stacked body of which the piezoelectric layer 373 is sandwiched between the first electrode 371 and the second electrode 372, which face each other. As in the other embodiments described above, a portion where the first electrode 371, the second electrode 372, and the piezoelectric layer 373 overlap each other in plan view configures each of the piezoelectric elements 37. The first electrode 371 and the piezoelectric layer 373 illustrated in Fig. 11 are formed on the outer surface of the diaphragm 36 so as to overlap the entire perimeter of each of the inner peripheries 345 of the pressure chambers C in plan view in a portion of each of the pressure chambers C. The first electrodes 371 and the piezoelectric layers 373 are not formed on the centers of the pressure chambers C. The first electrode 371 and the piezoelectric layer 373 are formed on the entire outer surface of the diaphragm 36 except for each of the portions of the pressure chambers C. However, the first electrode 371 and the piezoelectric layer 373 may not be formed except for each of the portion of the pressure chambers C. The shapes of inner peripheries of the first electrode 371 and the piezoelectric layer 373 are ellipses in plan view.

The second electrode 372 is separately stacked on the first electrode 371 on a side opposite to the diaphragm 36 for each of the piezoelectric elements 37 (for each of the nozzles N). The second electrode 372 is disposed so as to overlap the entire perimeter of each of the inner peripheries 345 of the pressure chambers C in plan view. In plan view, the shape of each of the inner peripheries of the second electrodes 372 is an ellipse and the shape of an outer periphery thereof is a substantially rectangle of which a side in the X-direction is longer than a side in the Y-direction. The diaphragm 36 of the fourth embodiment is the same single crystal silicon base as in the first embodiment and the second embodiment, and is configured so as to be integrated with the pressure chamber substrate 34.

According to the piezoelectric device 39 of the fourth embodiment having such a configuration, a piezoelectric strain and displacement occurs in each of the piezoelectric layers 373 sandwiched between the first electrode 371 and the second electrode 372 by applying a voltage to an area between the first electrode 371 and the second electrode 372. A pressure in each of the pressure chambers C changes by the diaphragm 36 vibrating in tandem with the piezoelectric strain of the piezoelectric layer 373. Also in the fourth embodiment, portions of the diaphragm 36, which overlap the pressure chambers C, are the vibration regions P.

As illustrated in Fig. 11, since the vibration regions P of the fourth embodiment are ellipses, short axes of the smallest rectangles Q including the vibration regions P shown with one dot chain lines in Fig. 11 are the short axes Gy of the vibration regions P and long axes of the smallest rectangles Q including the vibration regions P are the long axes Gx of the vibration regions P. In the fourth embodiment, the long axes of the ellipses configuring the vibration regions P are the long axes Gx of the vibration regions P, and the short axes of the ellipses are the short axes Gy of the vibration regions P. By setting the Poisson's ratio of the diaphragm 36 in the direction of the short axis Gy so as to be included in a range of a minimum value of the Poisson's ratio in a crystal plane inclusive to an average value of the Poisson's ratios in the crystal plane exclusive, the same effect as the first embodiment and the second embodiment can be achieved.

### Modification example

The forms and the embodiments given as examples above can be variously changed. Examples of forms of specific deformation are given as follows. Any two or more forms selected from the following examples and the forms described above can be combined as appropriate unless the selected forms are inconsistent with each other.
(1) Although a serial head that repeatedly causes the carriage 242, on which the liquid discharging heads 26 are mounted, to reciprocate in the X-direction is given as an example in the embodiments described above, the invention is also applicable to a line head in which the liquid discharging heads 26 are arranged over the entire width of the medium 12.
(2) The liquid discharging apparatus 10 given as an example in the embodiments described above can be adopted in various types of devices such as a facsimile device and a copier, in addition to a device exclusive to printing. The use of the liquid discharging apparatus 10 of the invention is not limited to printing. For example, a liquid discharging apparatus that discharges a color material solution is used as a manufacturing apparatus that forms a color filter of a liquid crystal display device, an organic electroluminescent (EL) display, and a field emission display (FED). A liquid discharging apparatus that discharges a conductive material solution is used as a manufacturing apparatus that forms wiring of a wiring substrate and an electrode. In addition, the liquid discharging apparatus is also used as a chip manufacturing apparatus that discharges a bioorganic solution as a type of a liquid.

## Claims

1. A piezoelectric device (39) comprising:
a pressure chamber (C);
a piezoelectric element (37); and
a diaphragm (36) disposed between the pressure chamber and the piezoelectric element, **characterized in that**
the diaphragm has a crystal plane of an anisotropic single crystal silicon base of which a Poisson's ratio varies according to a direction in the crystal plane,
in a vibration region (P) of the diaphragm, which overlaps the pressure chamber in plan view, the Poisson's ratio of the diaphragm in a short axis direction (Gy) of the smallest rectangle, which includes the vibration region, is included in a range of a minimum value of the Poisson's ratio in the crystal plane inclusive to an average value of the Poisson's ratio exclusive, and
the Poisson's ratio of the diaphragm in the short axis direction (Gy) is included in a range of the minimum value of the Poisson's ratio in the crystal plane inclusive to 0.0864 inclusive.

2. A piezoelectric device (39) according to claim 1,
wherein the single crystal silicon base is a base of which the crystal plane is a {100} plane.

3. A piezoelectric device (39) according to claim 1,
wherein the single crystal silicon base is a base of which the crystal plane is a (100) plane, and
an orientation (Dm) of the Poisson's ratio of the diaphragm in a short axis direction (Gy) of the smallest rectangle, which includes the vibration region, is included in a range of an orientation (D11) of 21 degrees toward a crystal orientation [010] with respect to a crystal orientation [011] (Dm) in the crystal plane to an orientation (D11') of 21 degrees toward a crystal orientation [001] with respect to the crystal orientation [011] in the crystal plane.

4. The piezoelectric device according to Claim 3,
wherein the orientation of the Poisson's ratio of the diaphragm in the short axis direction is included in a range of an orientation of 7 degrees toward the crystal orientation [010] with respect to the crystal orientation [011] in the crystal plane to an orientation of 7 degrees toward the crystal orientation [001] with respect to the crystal orientation [011] in the crystal plane.

5. A piezoelectric device (39) according to claim 1,
wherein the single crystal silicon base is a base of which the crystal plane is a (010) plane, and
an orientation of the Poisson's ratio of the diaphragm in a short axis direction (Gy) of the smallest rectangle, which includes the vibration region, is included in a range of an orientation of 21 degrees toward a crystal orientation [-100] with respect to a crystal orientation [-101] in the crystal plane to an orientation of 21 degrees toward a crystal orientation [001] with respect to the crystal orientation [-101] in the crystal plane.

6. The piezoelectric device according to Claim 5,
wherein the orientation of the Poisson's ratio of the diaphragm in the short axis direction is included in a range of an orientation of 7 degrees toward the crystal orientation [-100] with respect to the crystal orientation [-101] in the crystal plane to an orientation of 7 degrees toward the crystal orientation [001] with respect to the crystal orientation [-101] in the crystal plane.

7. A piezoelectric device (39) according to claim 1,
wherein the single crystal silicon base is a base of which the crystal plane is a (001) plane, and
an orientation of the Poisson's ratio of the diaphragm in a short axis direction of the smallest rectangle, which includes the vibration region, is included in a range of an orientation of 21 degrees toward a crystal orientation [010] with respect to a crystal orientation [-110] in the crystal plane to an orientation of 21 degrees toward a crystal orientation [00-1] with respect to the crystal orientation [-110] in the crystal plane.

8. The piezoelectric device according to Claim 7,
wherein the orientation of the Poisson's ratio of the diaphragm in the short axis direction is included in a range of an orientation of 7 degrees toward the crystal orientation [00-1] with respect to the crystal orientation [-110] in the crystal plane to an orientation of 7 degrees toward the crystal orientation [010] with respect to the crystal orientation [-110] in the crystal plane.

9. A piezoelectric device (39) according to claim 1,
wherein the single crystal silicon base is a base of which the crystal plane is a {110} plane.

10. A piezoelectric device (39) according to claim 1,
wherein the single crystal silicon base is a base of which the crystal plane is a (110) plane, and
an orientation (Dm) of the Poisson's ratio of the diaphragm in a short axis direction (Gy) of the smallest rectangle, which includes the vibration region, is included in a range of an orientation (D21) of 20 degrees toward a crystal orientation [-111] with respect to an orientation of 7 degrees from the crystal orientation [-111] toward a crystal orientation [-112] in the crystal plane to an orientation (D21') of 25 degrees toward the crystal orientation [-112] with respect to the orientation of 7 degrees from the crystal orientation [-111] toward the crystal orientation [-112] in the crystal plane.

11. The piezoelectric device according to Claim 10,
wherein the orientation of the Poisson's ratio of the diaphragm in the short axis direction is included in a range of an orientation of 13 degrees toward the crystal orientation [-111] with respect to the orientation of 7 degrees from the crystal orientation [-111] toward the crystal orientation [-112] in the crystal plane to an orientation of 15 degrees toward the crystal orientation [-112] with respect to the orientation of 7 degrees from the crystal orientation [-111] toward the crystal orientation [-112] in the crystal plane.

12. A piezoelectric device (39) according to claim 1,
wherein the single crystal silicon base is a base of which the crystal plane is a (011) plane, and
an orientation of the Poisson's ratio of the diaphragm in a short axis direction (Gy) of the smallest rectangle, which includes the vibration region, is included in a range of an orientation of 20 degrees toward a crystal orientation [1-11] with respect to an orientation of 7 degrees from the crystal orientation [1-11] toward a crystal orientation [1-12] in the crystal plane to an orientation of 25 degrees toward the crystal orientation [1-12] with respect to the orientation of 7 degrees from the crystal orientation [1-11] toward the crystal orientation [1-12] in the crystal plane.

13. The piezoelectric device according to Claim 12,
wherein the orientation of the Poisson's ratio of the diaphragm in the short axis direction is included in a range of an orientation of 13 degrees toward the crystal orientation [1-11] with respect to the orientation of 7 degrees from the crystal orientation [1-11] toward the crystal orientation [1-12] in the crystal plane to an orientation of 15 degrees toward the crystal orientation [1-12] with respect to the orientation of 7 degrees from the crystal orientation [1-11] toward the crystal orientation [1-12] in the crystal plane.

14. A piezoelectric device (39) according to claim 1,
wherein the single crystal silicon base is a base of which the crystal plane is a (101) plane, and
an orientation of the Poisson's ratio of the diaphragm in a short axis direction (Gy) of the smallest rectangle, which includes the vibration region, is included in a range of an orientation of 20 degrees toward a crystal orientation [11-1] with respect to an orientation of 7 degrees from the crystal orientation [11-1] toward a crystal orientation [12-1] in the crystal plane to an orientation of 25 degrees toward the crystal orientation [12-1] with respect to the orientation of 7 degrees from the crystal orientation [11-1] toward the crystal orientation [12-1] in the crystal plane.

15. The piezoelectric device according to Claim 14,
wherein the orientation of the Poisson's ratio of the diaphragm in the short axis direction is included in a range of an orientation of 13 degrees toward the crystal orientation [11-1] with respect to the orientation of 7 degrees from the crystal orientation [11-1] toward the crystal orientation [12-1] in the crystal plane to an orientation of 15 degrees toward the crystal orientation [12-1] with respect to the orientation of 7 degrees from the crystal orientation [11-1] toward the crystal orientation [12-1] in the crystal plane.

16. A liquid discharging head (26) comprising:
the piezoelectric device (39) according to any one of the preceding claims,
wherein a liquid that has filled the pressure chamber is discharged from a nozzle (N) by the piezoelectric element vibrating the diaphragm to change a pressure of the pressure chamber.

17. A liquid discharging apparatus (10) comprising:
the piezoelectric device (39) according to any one of claims 1 to 15,
wherein a liquid that has filled the pressure chamber is discharged from a nozzle (N) by the piezoelectric element vibrating the diaphragm to change a pressure of the pressure chamber.

## Patentansprüche

1. Piezoelektrische Vorrichtung (39), umfassend:
eine Druckkammer (C);
ein piezoelektrisches Element (37); und
eine Membran (36), die zwischen der Druckkammer und dem piezoelektrischen Element angeordnet ist, **dadurch gekennzeichnet, dass**
die Membran eine Kristallebene einer anisotropen Einzelkristallsiliziumbasis hat, deren Poisson-Verhältnis in Übereinstimmung mit einer Richtung in der Kristallebene variiert,
in einer Vibrationsregion (P) der Membran, die die Druckkammer in Draufsicht überlappt, das Poisson-Verhältnis der Membran in einer Kurzachsenrichtung (Gy) des kleinsten Rechtecks, das die Vibrationsregion enthält, in einem Bereich von einem Minimalwert des Poisson-Verhältnisses in der Kristallebene, inklusive, bis zu einem Durchschnittswert des Poisson-Verhältnisses, exklusive, enthalten ist, und
das Poisson-Verhältnis der Membran in der Kurzachsenrichtung (Gy) in einem Bereich eines Minimalwerts des Poisson-Verhältnisses in der Kristallebene, inklusive, bis 0,0864, inklusive, enthalten ist.

2. Piezoelektrische Vorrichtung (39) nach Anspruch 1,
wobei die Einzelkristallsiliziumbasis eine Basis ist, deren Kristallebene eine {100}-Ebene ist.

3. Piezoelektrische Vorrichtung nach Anspruch 1,
wobei die Einzelkristallsiliziumbasis eine Basis ist, deren Kristallebene eine (100)-Ebene ist, und
eine Orientierung (Dm) des Poisson-Verhältnisses der Membran in der Kurzachsenrichtung (Gy) des kleinsten Rechtecks, das die Vibrationsregion enthält, in einem Bereich von einer Orientierung (D11) von 21 Grad zu einer Kristallorientierung [010] in Bezug auf eine Kristallorientierung [011] (Dm) in der Kristallebene bis zu einer Orientierung (D11') von 21 Grad zu einer Kristallorientierung [001] in Bezug auf die Kristallorientierung [011] in der Kristallebene enthalten ist.

4. Piezoelektrische Vorrichtung nach Anspruch 3,
wobei die Orientierung des Poisson-Verhältnisses der Membran in der Kurzachsenrichtung in einem Bereich von einer Orientierung von 7 Grad zu der Kristallorientierung [010] in Bezug auf die Kristallorientierung [011] in der Kristallebene bis zu einer Orientierung von 7 Grad zu der Kristallorientierung [001] in Bezug auf die Kristallorientierung [011] in der Kristallebene enthalten ist.

5. Piezoelektrische Vorrichtung (39) nach Anspruch 1,
wobei die Einzelkristallsiliziumbasis eine Basis ist, deren Kristallebene eine (010)-Ebene ist, und
eine Orientierung des Poisson-Verhältnisses der Membran in einer Kurzachsenrichtung (Gy) des kleinsten Rechtecks, das die Vibrationsregion enthält, in einem Bereich von einer Orientierung von 21 Grad zu einer Kristallorientierung [-100] in Bezug auf eine Kristallorientierung [-101] in der Kristallebene bis zu einer Orientierung von 21 Grad zu einer Kristallorientierung [001] in Bezug auf die Kristallorientierung [-101] in der Kristallebene enthalten ist.

6. Piezoelektrische Vorrichtung nach Anspruch 5,
wobei die Orientierung des Poisson-Verhältnisses der Membran in der Kurzachsenrichtung in einem Bereich von einer Orientierung von 7 Grad zu der Kristallorientierung [-100] in Bezug auf die Kristallorientierung [-101] in der Kristallebene bis zu einer Orientierung von 7 Grad zu der Kristallorientierung [001] in Bezug auf die Kristallorientierung [-101] in der Kristallebene enthalten ist.

7. Piezoelektrische Vorrichtung (39) nach Anspruch 1,
wobei die Einzelkristallsiliziumbasis eine Basis ist, deren Kristallebene eine (001)-Ebene ist, und
eine Orientierung des Poisson-Verhältnisses der Membran in einer Kurzachsenrichtung des kleinsten Rechtecks, das die Vibrationsregion enthält, in einem Bereich von einer Orientierung von 21 Grad zu einer Kristallorientierung [010] in Bezug auf eine Kristallorientierung [-110] in der Kristallebene bis zu einer Orientierung von 21 Grad zu einer Kristallorientierung [00-1] in Bezug auf die Kristallorientierung [-110] in der Kristallebene enthalten ist.

8. Piezoelektrische Vorrichtung nach Anspruch 7, wobei die Orientierung des Poisson-Verhältnisses der Membran in der Kurzachsenrichtung in einem Bereich von einer Orientierung von 7 Grad zu der Kristallorientierung [00-1] in Bezug auf die Kristallorientierung [-110] in der Kristallebene bis zu einer Orientierung von 7 Grad zu der Kristallorientierung [010] in Bezug auf die Kristallorientierung [-110] in der Kristallebene enthalten ist.

9. Piezoelektrische Vorrichtung (39) nach Anspruch 1,
wobei die Einzelkristallsiliziumbasis eine Basis ist, deren Kristallebene eine {110}-Ebene ist.

10. Piezoelektrische Vorrichtung (39) nach Anspruch 1,
wobei die Einzelkristallsiliziumbasis eine Basis ist, deren Kristallebene eine (110)-Ebene ist und
eine Orientierung (Dm) des Poisson-Verhältnisses der Membran in einer Kurzachsenrichtung (Gy) des kleinsten Rechtecks, das die Vibrationsregion enthält, in einem Bereich von einer Orientierung (D21) von 20 Grad zu einer Kristallorientierung [-111] in Bezug auf eine Orientierung von 7 Grad von der Kristallorientierung [-111] zu einer Kristallorientierung [-112] in der Kristallebene bis zu einer Orientierung (D21') von 25 Grad zu der Kristallorientierung [-112] in Bezug auf die Orientierung von 7 Grad von der Kristallorientierung [-111] zu der Kristallorientierung [-112] in der Kristallebene enthalten ist.

11. Piezoelektrische Vorrichtung nach Anspruch 10,
wobei die Orientierung des Poisson-Verhältnisses der Membran in der Kurzachsenrichtung in einem Bereich von einer Orientierung von 13 Grad zu der Kristallorientierung [-111] in Bezug auf die Orientierung von 7 Grad von der Kristallorientierung [-111] zu der Kristallorientierung [-112] in der Kristallebene bis zu einer Orientierung von 15 Grad zu der Kristallorientierung [-112] in Bezug auf die Orientierung von 7 Grad von der Kristallorientierung [-111] zu der Kristallorientierung [-112] in der Kristallebene enthalten ist.

12. Piezoelektrische Vorrichtung (39) nach Anspruch 1,
wobei die Einzelkristallsiliziumbasis eine Basis ist, deren Kristallebene eine (011)-Ebene ist, und
eine Orientierung des Poisson-Verhältnisses der Membran in einer Kurzachsenrichtung (Gy) des kleinsten Rechtecks, das die Vibrationsregion enthält, in einem Bereich von einer Orientierung von 20 Grad zu einer Kristallorientierung [1-11] in Bezug auf eine Orientierung von 7 Grad von der Kristallorientierung [1-11] zu einer Kristallorientierung [1-12] in der Kristallebene bis zu einer Orientierung von 25 Grad zu der Kristallorientierung [1-12] in Bezug auf die Orientierung von 7 Grad von der Kristallorientierung [1-11] zu der Kristallorientierung [1-12] in der Kristallebene enthalten ist.

13. Piezoelektrische Vorrichtung nach Anspruch 12,
wobei die Orientierung des Poisson-Verhältnisses der Membran in der Kurzachsenrichtung in einem Bereich von einer Orientierung von 13 Grad zu der Kristallorientierung [1-11] in Bezug auf die Orientierung von 7 Grad von der Kristallorientierung [1-11] zu der Kristallorientierung [1-12] in der Kristallebene bis zu einer Orientierung von 15 Grad zu der Kristallorientierung [1-12] in Bezug auf die Orientierung von 7 Grad von der Kristallorientierung [1-11] zu der Kristallorientierung [1-12] in der Kristallebene enthalten ist.

14. Piezoelektrische Vorrichtung (39) nach Anspruch 1,
wobei die Einzelkristallsiliziumbasis eine Basis ist, deren Kristallebene eine (101)-Ebene ist, und
eine Orientierung des Poisson-Verhältnisses der Membran in einer Kurzachsenrichtung (Gy) des kleinsten Rechtecks, das die Vibrationsregion enthält, in einem Bereich von einer Orientierung von 20 Grad zu einer Kristallorientierung [11-1] in Bezug auf eine Orientierung von 7 Grad von der Kristallorientierung [11-1] zu einer Kristallorientierung [12-1] in der Kristallebene bis zu einer Orientierung von 25 Grad zu der Kristallorientierung [12-1] in Bezug auf die Orientierung von 7 Grad von der Kristallorientierung [11-1] zu der Kristallorientierung [12-1] in der Kristallebene enthalten ist.

15. Piezoelektrische Vorrichtung nach Anspruch 14,
wobei die Orientierung des Poisson-Verhältnisses der Membran in der Kurzachsenrichtung in einem Bereich von einer Orientierung von 13 Grad zu der Kristallorientierung [11-1] in Bezug auf die Orientierung von 7 Grad von der Kristallorientierung [11-1] zu der Kristallorientierung [12-1] in der Kristallebene bis zu einer Orientierung von 15 Grad zu der Kristallorientierung [12-1] in Bezug auf die Orientierung von 7 Grad von der Kristallorientierung [11-1] zu der Kristallorientierung [12-1] in der Kristallebene enthalten ist.

16. Flüssigkeitsabgabekopf (26), umfassend:
die piezoelektrische Vorrichtung (39) nach einem der vorstehenden Ansprüche,
wobei eine Flüssigkeit, die die Druckkammer gefüllt hat, aus einer Düse (N) ausgegeben wird, indem das piezoelektrische Element die Membran vibriert, um einen Druck der Druckkammer zu ändern.

17. Flüssigkeitsabgabeeinrichtung (10), umfassend:
die piezoelektrische Vorrichtung (39) nach einem der Ansprüche 1 bis 15,
wobei eine Flüssigkeit, die die Druckkammer gefüllt hat, aus einer Düse (N) ausgegeben wird, indem das piezoelektrische Element die Membran vibriert, um einen Druck der Druckkammer zu ändern.

## Revendications

1. Dispositif piézoélectrique (39) comprenant :
une chambre de pression (C) ;
un élément piézoélectrique (37) ; et
un diaphragme (36) disposé entre la chambre de pression et l'élément piézoélectrique, **caractérisé en ce que**
le diaphragme a un plan cristallin à base de silicium monocristallin anisotrope dont un coefficient de Poisson varie en fonction d'une direction dans le plan cristallin,
dans une région de vibration (P) du diaphragme, laquelle recouvre la chambre de pression dans une vue en plan, le coefficient de Poisson du diaphragme dans une direction d'axe court (Gy) du plus petit rectangle, qui comprend la région de vibration, est compris dans une plage allant d'une valeur minimale du coefficient de Poisson dans le plan cristallin de manière inclusive à une valeur moyenne du coefficient de Poisson de manière exclusive, et
le coefficient de Poisson du diaphragme dans la direction d'axe court (Gy) est compris dans une plage allant de la valeur minimale du coefficient de Poisson dans le plan cristallin de manière inclusive à 0,0864 de manière inclusive.

2. Dispositif piézoélectrique (39) selon la revendication 1,
dans lequel la base en silicium monocristallin est une base dont le plan cristallin est un plan {100}.

3. Dispositif piézoélectrique (39) selon la revendication 1,
dans lequel la base en silicium monocristallin est une base dont le plan cristallin est un plan (100), et une orientation (Dm) du coefficient de Poisson du diaphragme dans une direction d'axe court (Gy) du plus petit rectangle, qui comprend la région de vibration, est comprise dans une plage allant d'une orientation (D11) de 21 degrés vers une orientation cristalline [010] par rapport à une orientation cristalline [011] (Dm) dans le plan cristallin à une orientation (D11') de 21 degrés vers une orientation cristalline [001] par rapport à l'orientation cristalline [011] dans le plan cristallin.

4. Dispositif piézoélectrique selon la revendication 3,
dans lequel l'orientation du coefficient de Poisson du diaphragme dans la direction d'axe court est comprise dans une plage allant d'une orientation de 7 degrés vers l'orientation cristalline [010] par rapport à l'orientation cristalline [011] dans le plan cristallin à une orientation de 7 degrés vers l'orientation cristalline [01] par rapport à l'orientation cristalline [011] dans le plan cristallin.

5. Dispositif piézoélectrique (39) selon la revendication 1,
dans lequel la base en silicium monocristallin est une base dont le plan cristallin est un plan (010), et une orientation du coefficient de Poisson du diaphragme dans une direction d'axe court (Gy) du plus petit rectangle, qui comprend la région de vibration, est comprise dans une plage allant d'une orientation de 21 degrés vers une orientation cristalline [-100] par rapport à une orientation cristalline [-101] dans le plan cristallin à une orientation de 21 degrés vers une orientation cristalline [001] par rapport à l'orientation cristalline [-101] dans le plan cristallin.

6. Dispositif piézoélectrique selon la revendication 5,
dans lequel l'orientation du coefficient de Poisson du diaphragme dans la direction d'axe court est comprise dans une plage allant d'une orientation de 7 degrés vers l'orientation cristalline [-100] par rapport à l'orientation cristalline [-101] dans le plan cristallin à une orientation de 7 degrés vers l'orientation cristalline [001] par rapport à l'orientation cristalline [-101] dans le plan cristallin.

7. Dispositif piézoélectrique (39) selon la revendication 1,
dans lequel la base en silicium monocristallin est une base dont le plan cristallin est un plan (001), et
une orientation du coefficient de Poisson du diaphragme dans une direction d'axe court du plus petit rectangle, qui comprend la région de vibration, est comprise dans une plage allant d'une orientation de 21 degrés vers une orientation cristalline [010] par rapport à une orientation cristalline [-110] dans le plan cristallin à une orientation de 21 degrés vers une orientation cristalline [00-1] par rapport à l'orientation cristalline [-110] dans le plan cristallin.

8. Dispositif piézoélectrique selon la revendication 7,
dans lequel l'orientation du coefficient de Poisson du diaphragme dans la direction d'axe court est comprise dans une plage allant d'une orientation de 7 degrés vers l'orientation cristalline [00-1] par rapport à l'orientation cristalline [-110] dans le plan cristallin à une orientation de 7 degrés vers l'orientation cristalline [010] par rapport à l'orientation cristalline [-110] dans le plan cristallin.

9. Dispositif piézoélectrique (39) selon la revendication 1,
dans lequel la base en silicium monocristallin est une base dont le plan cristallin est un plan {110}.

10. Dispositif piézoélectrique (39) selon la revendication 1,
dans lequel la base en silicium monocristallin est une base dont le plan cristallin est un plan (110), et
une orientation (Dm) du coefficient de Poisson du diaphragme dans une direction d'axe court (Gy) du plus petit rectangle, qui comprend la région de vibration, est comprise dans une plage allant d'une orientation (D21) de 20 degrés vers une orientation cristalline [-111] par rapport à une orientation de 7 degrés de l'orientation cristalline [-111] vers une orientation cristalline [-112] dans le plan cristallin à une orientation (D21') de 25 degrés vers l'orientation cristalline [-112] par rapport à l'orientation de 7 degrés de l'orientation cristalline [-111] vers l'orientation cristalline [-112] dans le plan cristallin.

11. Dispositif piézoélectrique selon la revendication 10,
dans lequel l'orientation du coefficient de Poisson du diaphragme dans la direction d'axe court est comprise dans une plage allant d'une orientation de 13 degrés vers l'orientation cristalline [-111] par rapport à l'orientation de 7 degrés de l'orientation cristalline [-111] vers l'orientation cristalline [-112] dans le plan cristallin à une orientation de 15 degrés vers l'orientation cristalline [-112] par rapport à l'orientation de 7 degrés de l'orientation cristalline [-111] vers l'orientation cristalline [-112] dans le plan cristallin.

12. Dispositif piézoélectrique (39) selon la revendication 1,
dans lequel la base en silicium monocristallin est une base dont le plan cristallin est un plan (011), et
une orientation du coefficient de Poisson du diaphragme dans une direction d'axe court (Gy) du plus petit rectangle, qui comprend la région de vibration, est comprise dans une plage allant d'une orientation de 20 degrés vers une orientation cristalline [1-11] par rapport à une orientation de 7 degrés de l'orientation cristalline [1-11] vers une orientation cristalline [1-12] dans le plan cristallin à une orientation de 25 degrés vers l'orientation cristalline [1-12] par rapport à l'orientation de 7 degrés de l'orientation cristalline [1-11] verts l'orientation cristalline [1-12] dans le plan cristallin.

13. Dispositif piézoélectrique selon la revendication 12,
dans lequel l'orientation du coefficient de Poisson du diaphragme dans la direction d'axe court est comprise dans une plage allant d'une orientation de 13 degrés vers l'orientation cristalline [1-11] par rapport à l'orientation de 7 degrés de l'orientation cristalline [1-11] vers l'orientation cristalline [1-12] dans le plan cristallin à une orientation de 15 degrés vers l'orientation cristalline [1-12] par rapport à l'orientation de 7 degrés de l'orientation cristalline [1-11] vers l'orientation cristalline [1-12] dans le plan cristallin.

14. Dispositif piézoélectrique (39) selon la revendication 1,
dans lequel la base en silicium monocristallin est une base dont le plan cristallin est un plan (101), et
une orientation du coefficient de Poisson du diaphragme dans une direction d'axe court (Gy) du plus petit rectangle, qui comprend la région de vibration, est comprise dans une plage allant d'une orientation de 20 degrés vers l'orientation cristalline [11-1] par rapport à une orientation de 7 degrés de l'orientation cristalline [11-1] vers l'orientation cristalline [12-1] dans le plan cristallin à une orientation de 25 degrés vers l'orientation cristalline [12-1] par rapport à l'orientation de 7 degrés de l'orientation cristalline [11-1] vers l'orientation cristalline [12-1] dans le plan cristallin.

15. Dispositif piézoélectrique selon la revendication 14,
dans lequel l'orientation du coefficient de Poisson du diaphragme dans la direction d'axe court est comprise dans une plage allant d'une orientation de 13 degrés vers l'orientation cristalline [11-1] par rapport à l'orientation de 7 degrés de l'orientation cristalline [11-1] vers l'orientation cristalline [12-1] dans le plan cristallin à une orientation de 15 degrés vers l'orientation cristalline [12-1] par rapport à l'orientation de 7 degrés de l'orientation cristalline [11-1] vers l'orientation cristalline [12-1] dans le plan cristallin.

16. Tête de décharge de liquide (26) comprenant :
le dispositif piézoélectrique (39) selon l'une quelconque des revendications précédentes,
dans laquelle un liquide qui a rempli la chambre de pression est déchargé à partir d'une buse (N) par l'élément piézoélectrique faisant vibrer le diaphragme pour changer une pression de la chambre de pression.

17. Appareil de décharge de liquide (10) comprenant :
le dispositif piézoélectrique (39) selon l'une quelconque des revendications 1 à 15,
dans lequel un liquide qui a rempli la chambre de pression est déchargé à partir d'une buse (N) par l'élément piézoélectrique qui fait vibrer le diaphragme pour changer une pression de la chambre de pression.
